# EUROPEAN PATENT SPECIFICATION

(11) **EP 0 397 663 B1**
(45) Date of publication and mention of the grant of the patent: **18.05.1994**
(21) Application number: 88910275.2
(22) Date of filing: 14.10.1988
(51) Int. Cl.: C25D 3/56

(54) **ELECTRODEPOSITION OF TIN-BISMUTH ALLOYS**
ELEKTRONIEDERSCHLAG VON ZINN-WISMUT-LEGIERUNGEN
ELECTRODEPOSITION D'ALLIAGES D'ETAIN-BISMUTH

(43) Date of publication of application: 22.11.1990
(73) Proprietor: ATOCHEM NORTH AMERICA, INC., Philadelphia, Pennsylvania 19102 (US)
(72) Inventor: WILSON, Harold, P., Huron, OH 44839 (US)
(74) Representative: Stoner, Gerard Patrick
(86) International application number: US8803536
(87) International publication number: WO9004048

(56) References cited:
- EP-A- 0 255 558
- SU-A- 305 208
- SU-A- 463 747
- SU-A- 467 145
- SU-A- 697 610
- US-A- 3 198 877
- US-A- 3 360 446
- US-A- 3 663 384
- US-A- 4 252 618
- US-A- 4 331 518
- US-A- 4 565 610
- US-A- 4 717 460
- Seeds, materials and methods, pp. 64-68, Sept. 1950

## Description

This invention relates to the electrodeposition of tin-bismuth Alloys.

Alloys of tin and lead have been used in a wide variety of applications such as plating for circuit boards, rust inhibiting coatings for metals and for solder. An increased awareness of health hazards and environmental hazards posed by lead has required the taking of handling and disposal precautions which increase costs. In some situations, therefore, it would be desirable to replace tin-lead alloys with some other alloy having acceptable characteristics but without the risks associated with tin-lead alloys.

Moreover, tin-lead alloys are not entirely satisfactory in some temperature-sensitive applications where the application of heat may be undesirable. They have been conventionally used as plating for multilayer circuit boards and as a eutectic solder for bonding together tin-lead plated circuit boards. However the heat required to melt eutectic tin-lead alloy solder is sufficient sometimes to damage components of a circuit board, or impair its conductivity characteristics.

Tin-bismuth alloys have characteristics making them attractive replacements for tin-lead alloys. They do not present the same health and environmental problems. A tin-bismuth eutectic alloy has a melting point about 50°C lower than a tin-lead eutectic alloy, making it an attractive material for plating and soldering layered circuit boards.

Conventional bismuth salts used in conventional electrolytes are often unstable and liable to undesirable hydrolytic precipitation. To prevent or minimise this, additives such as citric acid and chelating agents are commonly used. However, conventional baths containing such additives may be difficult to maintain and do not provide versatile, commercially satisfactory baths and cells for depositing bismuth-containing alloys.

In the prior art, US-A-4331518 discloses electroplating tin-bismuth alloys which may have as much as 10 or 14% bismuth. Soluble bismuth is provided in the bath as a chelated acid bismuth sulphate gluconate.

US-A-4565610 discloses the possibility of using small quantities of bismuth nitrate as an additive to aid in the deposition of tin-lead alloy. The electroplating bath may contain an alkyl sulphonic acid. The bismuth nitrate is said to lower the current density of the bath, or, when used in conjunction with an aromatic aldehyde or alkaline oxide, to improve the brightness of the tin-lead deposit.

EP-A-255558 describes the use of organic sulphonic acids of the general formula (X₁)ₙ-R-SO₃H, among which methane sulphonic acid is exemplified, to enable the plating of bismuth with any of a number of other metals such as tin, indium and lead. The sulphonic additive enables the co-plating of bismuth with these other metals by approximating their deposition potentials.

The present invention provides the use of more than 200g/l of methane sulphonic acid to inhibit hydrolytic precipitation of bismuth, in an electroplating process which electroplates tin-bismuth alloy of at least 10wt% bismuth from an aqueous electroplating bath containing soluble tin and bismuth species.

It has been found that tin-bismuth alloy having nearly any desired bismuth content may be electroplated onto a conductive substrate from a relatively simple versatile electroplating bath which includes sufficient amounts of free alkyl sulfonic acid electrolyte. The deposition of alloys having a wide range of bismuth content is possible, in part, because bismuth has been found to be more hydrolytically stable in the presence of methane sulfonic acid, than in conventional electrolyte solutions used for bismuth such as sulfuric acid or chloride-citrate. Using a sufficient amount of methane sulfonic acid electrolyte therefore is one aspect of the present invention which makes possible the electrodeposition of tin-bismuth alloys having virtually any desired bismuth content.

Hydrolytic precipitation in a multi-component electrolyte solution probably is quite complex, but in the case of bismuth, the following formula, in which soluble bismuth is provided by bismuth trimethane sulfonate, may represent the mechanism of hydrolytic precipitation in a simplistic manner: 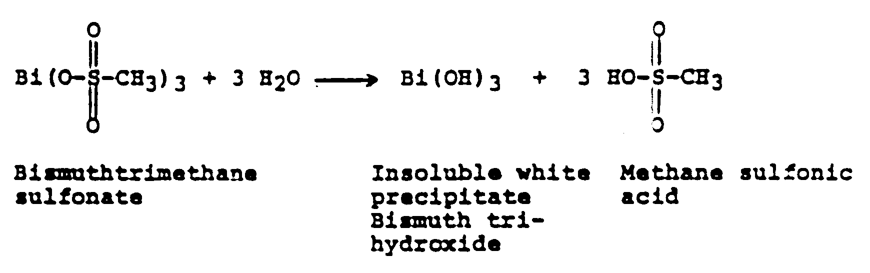
Generally, when the free MSA concentration in the plating bath is below 200 grams per liter, for example below about 150 grams per liter, the bath may undergo undesirable hydrolytic precipitation of bismuth after a period of time. When concentrations of about 200 grams per liter free MSA are maintained in the bath, hydrolytic precipitation seldom occurs and the degree of precipitation is very moderate. At concentrations of about 250 grams per liter free MSA, precipitation of bismuth ordinarily does not occur at observable levels.

Soluble bismuth available to form a tin-bismuth alloy on a conductive substrate may be provided in a bath of the present invention by adding a bismuth salt, preferably bismuth alkyl sulfonate, directly to the bath or by a soluble bismuth metal anode. Either source of soluble bismuth may be used without the other but they are frequently used together.

For most applications of the present invention, the amount of soluble bismuth in the aqueous acidic plating bath ordinarily ranges from about .05 grams per liter of the bath to about 150 grams per liter of the bath, preferably, from about .05 grams per liter of the bath to about 80 grams per liter of the bath. Soluble bismuth is preferably provided in bath solutions of MSA initially in the form of bismuth trimethane sulfonate concentrate (alternatively referred to as bismuth methane sulfonate concentrate).

Bismuth trimethane sulfonate concentrate may be prepared by reacting bismuth trioxide with 70% methane sulfonic acid. It has been found that a product bath solution of 200-225 grams of bismuth trimethane sulfonate per liter bismuth is stable only when there is at least 200 grams per liter free methane sulfonic acid in the solution. As the electroplating process proceeds, additional bismuth trimethane sulfonate concentrate may be added to maintain an adequate soluble bismuth content in the bath.

In one embodiment, a soluble bismuth anode is used to recharge the bismuth plating bath so that further additions of bismuth methane sulfonate are minimized or not required during operation. The bismuth anode is preferably constructed of soluble bismuth metal, typically cast high purity bismuth. It has been found useful to bag the soluble bismuth anode with polypropylene cloth. Other components of cells, such as the container for the electrolyte solution, are conventional. Those skilled in the art are well acquainted with electroplating cells and their assembly and would therefore be able to provide a cell in accordance with the teachings herein.

When bismuth anodes are used to supply soluble bismuth, the immersion area of the anodes will have to be regulated to control the solubilization rate to meet plating demand and maintain solution concentration. Bismuth anodes generally produce tin-bismuth co-plates having clean grayish white satin finishes.

It has been found that bismuth anodes in plating baths containing about 250 grams per liter free methane sulfonic acid are very active and tend to increase the soluble bismuth concentration, thereby slowly upsetting the bismuth/tin ratio in the co-plate to contain about 5% bismuth. This may be counter-acted by adding additional tin to the bath. However, the soluble bismuth build-up is preferably minimized by controlling the immersion area of the bismuth anode to provide an anode current density near 11.8 A/dm² (110 amp/ft²) where the anode current efficiency probably becomes sufficiently low to inhibit the solubilization rate of bismuth.

When chelated bismuth is used in the bath as the source of bismuth ions, it also may be possible to substitute tin anodes for the bismuth anodes.

The following three chelating compounds may be used to provide chelated bismuth to the electrolyte bath:
(1) Tetraammonium bismuth dinitrilotriacetate Chelate. (approx. 26% bismuth in water soluble transparent crystals)
(2) Diammonium bismuth diethylene triaminepentaacetate Chelate. (approx. 325 grams per liter bismuth in concentrate)
(3) Trimethane sulfonic acid bismuth trimethane sulfonate trigluconate Chelate Complex. (approx. 200 grams per liter bismuth in concentrate)

The concentrations of these bismuth sources in the bath are calculated in the same manner as described for bismuth methane-sulfonate except that the free acid concentration may be less (say approx. 100-150 grams per liter, preferably about 150 grams per liter). These chelated compounds, particularly chelate No. 2, at high concentrations tend to saturate and cause a spontaneous breakdown precipitation in the MSA bath. The first chelate listed above is ordinarily the preferred chelate in MSA electrolyte baths.

Processes for making the foregoing bismuth chelates are described in the ensuing paragraphs.

### Tetrammonium bismuth dinitrilotriacetate Chelate.

| Reaction Formulation | |
|---|---|
| Component | Amount |
| Bismuth (Bi) | 20.0 g |
| Bismuth trioxide (Bi₂O₃) | 22.2 g |
| Nitrilotriacetic acid (2m/m Bi) | 36.6 g |
| Distilled Water | 200 ml |
| Ammonium hydroxide (29% NH₃) | 25 ml |

A slurry of Bi₂O₃ and nitrilotriacetate (NTA) is agitated and heated at 80°C for about one hour. The NH₄OH is added slowly to form a water clear solution. If crystals appear when the solution is cooled to room temperature a little distilled water is added to redissolve them. The solution is near saturation at about 200 grams per liter bismuth. The pH of the solution should be near 6.8 at 25°C. Any residue is removed by filtration through hardened ashless paper. The filtrate may be vacuum evaporated at 87.8-97.8 kPa (26-29 in. Hg) and < 80°C to recover the crystals. The crystals may be vacuum dried at 97.8 kPa (29 in. Hg) and < 50°C.

The bismuth content of the crystals is typically 26.4% by analysis. The crystals dissolve readily in water to form clear solutions that are stable at pH values at 7.0. Mildly alkaline (pH 7.5 - 10) solution are somewhat unstable. However, increased alkalinity (pH 10+) restores stability.

### Diammonium bismuth diethylene triaminepentaacetate Chelate (DTPA).

A typical procedure for synthesis of the diammonium bismuth diethylene triaminepentaacetate chelate is described below:

| Reaction Formulation | |
|---|---|
| Component | Amount |
| Bismuth (Bi) | 60 g |
| Bismuth trioxide (Bi₂O₃), 98.5% | 67.9 g |
| Diethylene triaminepentaacetic acid (DTPA) (1 m/m Bi) | 116.0 g |
| Distilled or D.I. Water | 200 ml |
| Ammonium hydroxide (29% NH₃) | 39 ml |
| 30% Hydrogen Peroxide | 0.5 ml |

### Reaction Procedure

The reactor is a 600 ml thick-walled borosilicate glass (PYREX)® beaker with a TEFLON® encapsulated magnetic stirrer on a THERMOLYNE STIR-PLATE®. A cover glass and a thermometer are available.

The water in added first and agitated. Then the DTPA is added to form a white slurry. The NH₄OH is added to dissolve the DTPA. Heating is started. When the solution in practically clear the bismuth trioxide is added to form a yellow slurry. After about 1.5 hours the solution temperature reaches about 90°C and the solution has a slight haze and a volume of about 300 ml. Then the cover glass is removed to promote evaporation to about 200 ml. The solution is cooled to room temperature and filtered at low vacuum through REEVE ANGEL 934 AH glass fibre paper to yield 173 ml clear yellow filtrate typically having a density of 1.54 g/ml at room temperature and analyzing 328 grams per liter bismuth. The product concentrate generally has a pH at room temperature of at least 6.0.

### Trimethane sulfonic acid bismuth trimethane sulfonate Triglutonate Chelate Complex.

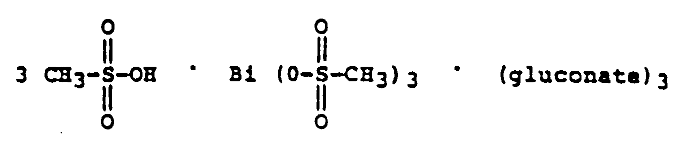

| Reaction Formulation | |
|---|---|
| Component | Amount |
| Bismuth (Bi) | 20 g |
| Bismuth trioxide (Bi₂0₃), 98.5% | 22.3 g |
| 50% Gluconic Acid (3 m.gl.ac./m.Bi) | 91.3 ml |
| Distilled or D.I. Water | 30 ml |
| 70% Methane Sulfonic Acid | 58.1 ml |

### Reaction Procedure

The reactor is a 250 ml thick-walled borosilicate glass beaker with a magnetic stirrer on a THERMOLYNE STIR-PLATE®. A cover glass and thermometer are available.

The water is added first, followed by the gluconic acid. The solution is agitated and heating starts as the bismuth trioxide is added to form a slurry. The slurry is heated at about 94°C for nearly 3 hours. 70% MSA is then added in increments for another hour. When all of the MSA is added at 86.5°C the solution becomes clear dark red. Over another 2 hours the hydrogen peroxide is added drop wise to oxidize any bismuthite formed and the product solution is cooled to room temperature to yield about 125 ml of slightly viscous dark red solution. About 0.5 ml of the product solution is diluted 500/1 with D.I. water and shows no signs of hydrolysis or precipitation. Typically the product solution analyzes 174 grams per liter bismuth at a density of 1.518 g/ml at 25°C.

Soluble tin may be provided to a bath of the present invention by a salt of a tin compound or a tin soluble anode. Either source of tin may be used alone or they may be used together.

The preferred salt of a tin compound useful in the aqueous acidic electroplating bath is stannous methane sulfonate.

The preferred amount of a tin salt, in terms of tin content in the bath, ranges from about .05 grams of soluble tin per liter of the bath to about 80 grams of soluble tin per liter of the bath, preferably from about .05 grams of soluble tin per liter of the bath to about 50 grams of soluble tin per liter of the bath. A preferred range of stannous methane sulfonate is from about .13 grams per liter to about 208 grams per liter, more preferably from about 0.13 grams per liter to about 104 grams per liter. These amounts of stannous methane sulfonate provide, respectively, from about .05 grams to about 80 grams of soluble tin per liter of bath and from about .05 grams to about 50 grams of soluble tin per liter of bath. Generally, for most commercial purposes, soluble tin concentrations in the bath below about 5 grams per liter will seldom be practical.

Stannous methane sulfonate is preferably supplied in a concentrate containing about 300 grams per liter stannous tin and 10-30 grams per liter free methane sulfonic acid. Stannous methane sulfonate concentrate may be made by reacting stannous oxide with methane sulfonic acid. The concentrate may also be formed electrolytically using a tin anode in a membrane cell containing MSA.

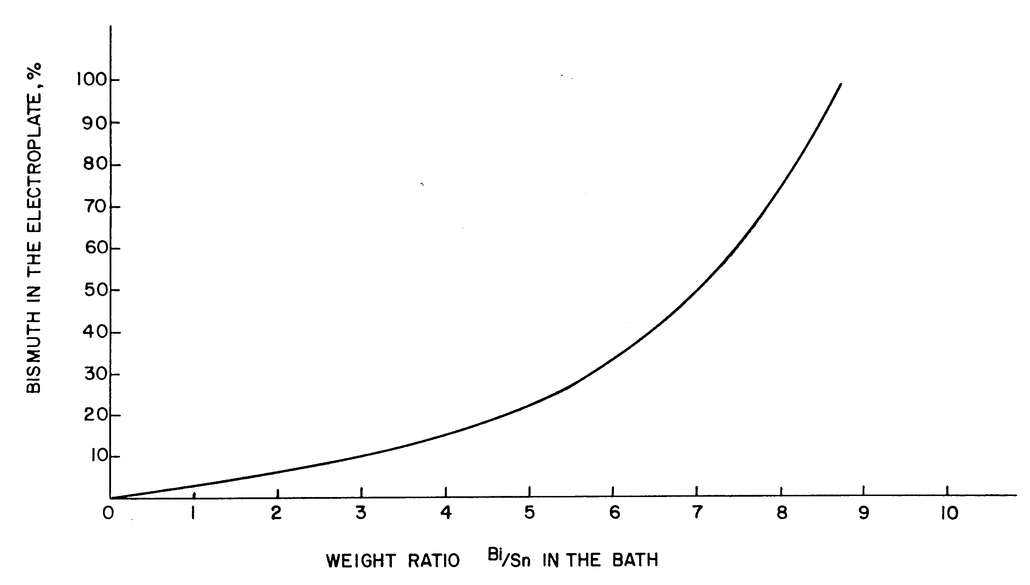

As illustrated in the Figure, a correlation curve of percent bismuth in satin electroplate (tin-bismuth co-plate, sometimes referred to as alloy plate) as a function of the weight ratio of bismuth to total tin in the bath was derived from analyses of simultaneous samples of tin-bismuth co-plates and the plating bath over a wide range of alloys from about 10% bismuth to about 90% bismuth. The bismuth content of the tin-bismuth electro co-plates on the cathode panels range from about 3.38% to about 98.48%. The weight ratio of bismuth to tin in the baths ranged from about 0.30 to about 9.50 and the weight concentration of total tin plus bismuth spanned about 27 to about 66.5 grams per liter. The correlation curve of percent bismuth in the tin-bismuth electro co-plate as a function of the weight ratio of bismuth to total tin in the bath is based on chemical analyses of samples taken through the above mentioned ranges. Plating variables other than soluble bismuth and tin content, of course, may be adjusted to provide a desired co-plate composition at the desired rate of electrodeposition. The plater could, for instance, adjust current density to effect the desired average percent bismuth in the co-plate. Making such adjustments is within the ability of a person of ordinary skill in the art. The illustrated correlation curve is therefore an accurate guide for calculating both concentrations of tin and bismuth for the full range of tin-bismuth alloys and particularly for alloys having 10-90% bismuth in the co-plate.

A straight-line correlation of percent bismuth as a function of the weight ratio of bismuth to total tin in the bath has been found in the range 0-15% bismuth in the co-plate. In the range of 1-2% bismuth in the co-plate there may be another straight-line correlation with a higher slope than the slope appearing in the Figure as shown in U.S. Patent No. 4,331,518. The illustrated correctional curve, however is an useful guide for bath composition even at the lowest and highest ranges of bismuth content.

The method for calculating the bath formulation of the present invention is based on the desired percentage bismuth in the tin-bismuth co-plate. The desired total bismuth content of the co-plate is selected. The correlation curve may be used to find the weight ratio of bismuth to tin corresponding to the percentage bismuth in the co-plate. A soluble tin concentration for the bath is selected and is multiplied by the weight ratio of bismuth to tin to provide the bismuth concentration needed for the bath. The volumes of bismuth methane sulfonate concentrate and stannous methane sulfonate concentrate for one liter of the bath may then be calculated according to the respective bismuth and tin analyses of the concentrates. Ordinarily, the free methane sulfonic acid contributed by the concentrates is subtracted from 250 grams per liter free methane sulfonic acid and the balance is used to calculate the volume of 70% methane sulfonic acid (say at 938 grams per liter 100% MSA) to add before the concentrates.

The bismuth content of the electroplate, of course, is determined by the weight ratio of bismuth to tin in the plating bath. If a broad range of tin concentration of 1-6 oz/gal or 7.5-45 grams per liter is selected then the bismuth in the bath should range from 0.8-44 oz/gal or 6-330 grams per liter for 5-58% bismuth in the co-plate. It is preferable to determine the best distribution of tin and bismuth concentrations in the plating bath for a given bismuth content in the electroplate according to the correlation curve.

For optimum bath stability and inhibition of hydrolytic precipitation of bismuth, when bismuth anodes are used and tin in the co-plate is replaced by adding acid stannous methane sulfonate concentrate to the bath at frequent intervals, the minimum free methane sulfonic acid concentration is from about 200-250 grams per liter and the preferred concentration is near 250 grams per liter.

Electroplating baths of the present invention may contain conventional amounts of additives such as surfactants, grain refiners, primary and/or secondary brighteners. Modified aromatic aldehydes (or ketones) and/or modified alkylene oxides or their analogs. These additives may be components of a brightening and leveling system such as BRI-TIN® and ULTRA STAN-100® produced by M & T Chemicals, Inc., formerly the Vulcan Materials Company.

The BRI-TIN® additive system imparts a mirror bright finish to the tin-bismuth co-plate. ULTRA STAN-100® is a system for promoting satin white tin plates having excellent reflowing and solderability characteristics in acid plating baths. It consists of two solutions, a Primary Addition Solution which is used mainly to make up the bath, and an Activator Solution which is added mainly to satisfy plating demand. These solutions contain the surfactants, brightness, levelers and enhancers necessary for promoting the desired satin white finish to the electro co-plate of tin-bismuth. The particular leveling and brightening system is an not essential feature, however, of the invention.

Different leveling and brightening systems may result in some alteration of the correlation of percentage bismuth in the co-plate as a function of the weight ratio of bismuth to total tin in the bath or cell. Thus, ULTRA STAN-100® and BRI-TIN® may result in correlation curves similar in form but different in curvature and having different correlation equation constants. Such alterations, however, may readily be anticipated by and accounted for by a person skilled in the art.

The conductive substrate or cathode of the electroplating cell may be any object which is conductive of electricity. Frequently, such objects are composed of metals such as iron, nickel, stainless steel, zinc, copper, or combinations of metals. The foregoing metals are examples of conventional conductive substrates but the spectrum of conductive substrates which may be plated in accordance with the present invention is not limited to the listed metals.

The anode of the electroplating cell is preferably a soluble bismuth metal anode that functions as a source of soluble bismuth. However, other anodes useful in the present invention include tin metal anodes. Insoluble anodes, such as zircalloy, pyrolitic graphite and platinum, could be used but are not preferred since they often provide poor quality in tin-bismuth electroplates and excessive oxidation of stannous tin.

The ratio of anode area to cathode area needs to be regulated for the proper anode current density to control the rate of anode solubilization to meet the plating requirement and to prevent build up of the soluble bismuth concentration in the bath. Soluble bismuth build-up upsets the weight ratio of bismuth to tin to change the bismuth content of the co-plate. For 58% bismuth in the co-plate the ratio of bismuth anode area to cathode area probably would be in the order of about 0.5/1. For higher bismuth content the ratio probably would be on the order of 2/1.

In a typical process an aqueous acidic electroplating bath is prepared in an electroplating vessel known to the art and is circulated vigorously at room temperature (15°C to 25°C). An anode, preferably soluble bismuth metal anode, which can be wrapped or bagged in polypropylene, is immersed or placed into the bath and the current is turned on. A cathode current density from 0.22 to 4.3 A/dm² (2 to 40 amp/ft²) should ordinarily be maintained. The conductive substrate with an anode area/cathode area ratio adjusted according to desired bismuth content of the tin-bismuth co-plate is then immersed into the aqueous acidic electroplating bath and reciprocated moderately.

The conductive substrate is immersed in the bath and remains immersed for a time sufficient to deposit a variable alloy coating of tin-bismuth of the desired thickness upon the conductive substrate. The conductive substrate is subsequently withdrawn from the aqueous acidic electroplating bath.

It is beneficial to maintain the current in the bath until the conductive substrate has been completely withdrawn. This minimizes smutting of the plate caused by displacement of bismuth from the solution at high concentration by the substrate.

The plated conductive substrate should be washed thoroughly as quickly as possible to minimize staining.

This invention is further illustrated in the following Examples. It should be understood, however, that the invention is not limited to the specific details of the Examples.

### PREPARATION OF THE CONDUCTIVE SUBSTRATE

Conductive substrates used for the electrodeposition of bismuth in Examples 1-4 were steel panels (25 cm² plating area) from Hull cell panels stripped of zinc electrocoat in 1:1 HCl and activated in 10% methanesulfonic acid at room temperature, with thorough washing with demineralized water after each treatment. The stripped panels then were electroplated with 0.15 - 0.25 ml copper in an acid cupric methane sulfonate bath as described in Table 1 before being electroplated with 0.1 to 1.0 ml bismuth. It was found that the adhesion of the electro copper plate to the steel panel was very much improved by a very short dip (e.g. 5-10 seconds) of the stripped panel in 20-50 grams per liter HNO₃ at room temperature and by very thorough washing before activation in 10% methanesulfonic acid.

Table 1 contains a listing of the bath composition for the electroplating of the Hull cell panels with copper and Table 2 contains a listing of the plating conditions and solution characteristics for the bath used to plate the panels with copper. Table 3 lists the plating conditions and solution characteristics that were common throughout Examples 1-4.

**TABLE 1**

| Component | Concentration (g/l) |
|---|---|
| Copper | 25 |
| Free Methanesulfonic Acid | 40 |
| Cupric Methane Sulfonate Concentrate (129 g/l Cu, 11 g/l Free MSA) | 193.8 ml/l |
| 69.5% Methanesulfonic Acid (938 g/l 100% MSA) | 40.4 ml/l |

**TABLE 2**

| Plating Conditions: | |
|---|---|
| Temperature | 20°C-25°C (Room Temp.) |
| Agitation | None |
| Anode | Rolled Electrolytic Cu |
| Ratio Anode Area to Cathode Area | 2:1 |
| Cathode Current Density A/dm² | 0.22-2.7 (2 to 25 A/foot²) |
| Cathode Current Efficiency | 100% |

| Solution Characteristics: | |
|---|---|
| Clarity | Water clear |
| Color | Slight yellow tint |
| Residue | Practically none |

**TABLE 3**

| Plating Conditions: | |
|---|---|
| Temperature, °C | Room (20°C-25°C) |

| Agitation | |
|---|---|
| solution circulation | Vigorous |
| cathode reciprocation | Moderate |
| Anodes | Cast high purity bismuth bagged with polypropylene |
| Ratio anode area to cathode area | adjusted according to the desired percentage of bismuth in the tin-bismuth co-plate. |

| Solution Characteristics: | |
|---|---|
| Clarity | Water clear |
| Color | Slight yellow tint |
| Residue | Practically none |

### EXAMPLE 1

The panels electroplated in the electroplating bath of Table 4 resulted in a conductive substrate with an electrodeposited alloy coating comprising 90% tin/10% bismuth.

**TABLE 4**

| | ml/l | g/l |
|---|---|---|
| Total Tin | | 15.0 |
| Stannous Methane Sulfonate Concentrate | 48.7 | |
| Bismuth | | 24.0 |
| Bismuth Methane Sulfonate Concentrate | 109.0 | |
| Free Methane Sulfonic Acid | | 250.0 |
| 69.5% Methane Sulfonic Acid | 241 | |
| ULTRA STAN-100® Primary Addition Solution (3-1/2% v/v) | 35 | |
| ULTRA STAN-100® Activator Solution (2-1/2% v/v) | 25 | |
| Working Range of Cathode Current Density (A/dm²) | 0.22 to 4.3 (2-40 amp/ft²) | |
| Cathode Current Efficiency | 95+% | |

### EXAMPLE 2

The panels electroplated in the electroplating bath of Table 5 resulted in a conductive substrate with an electrodeposited alloy coating comprised of 42% tin/58% bismuth. This proportion of bismuth to tin constitutes a eutectic coating.

**TABLE 5**

| | ml/l | g/l |
|---|---|---|
| Total Tin | | 7.5 |
| Stannous Methane Sulfonate Concentrate | 24.4 | |
| Bismuth | | 55.0 |
| Bismuth Methane Sulfonate Concentrate | 275.0 | |
| Free Methane Sulfonic Acid | | 250.0 |
| 69.5% Methane Sulfonic Acid | 200.0 | |
| ULTRA STAN-100® Primary Addition Solution (3-1/2% v/v) | 35.0 | |
| ULTRA STAN-100® Activator Solution (4% v/v) | 40.0 | |
| Working Range of Cathode Current Density (A/dm²) | 0.22 to 2.2 (2-20 amp/ft²) | |
| Cathode Current Efficiency | 80% | |

### EXAMPLE 3

The panels electroplated in the electroplating bath of Table 6 resulted in a conductive substrate with an electrodeposited alloy coating comprising 14.5% tin/85.5% bismuth.

**TABLE 6**

| | ml/l | g/l |
|---|---|---|
| Total Tin | | 6.4 |
| Stannous Methane Sulfonate Concentrate | 20.8 | |
| Bismuth | | 49.6 |
| Bismuth Methane Sulfonate Concentrate | 228.0 | |
| Free Methane Sulfonic Acid | | 250 |
| 69.5% Methane Sulfonic Acid | 200 | |
| ULTRA STAN-100® Primary Addition Solution (3-1/2% v/v) | 35.0 | |
| ULTRA STAN-100® Activator Solution (4% v/v) | 40.0 | |
| Working Range of Cathode Currant Density | 0.22 to 2.2 A/dm² (2-20 amp/ft²) | |
| Cathode Current Efficiency | 80% | |
| Ratio of Anode Area to Cathode Area | 2:1 | |

Tin-bismuth alloys that may be made in accordance with the present invention include: 1) 42% tin/ 58% bismuth which forms a eutectic material having a melting point of about 138°C, approximately 50°C lower than tin-lead eutectic composition; and 2) 25/75 or 16/84 tin-bismuth alloys sandwiched in plastic sheets to make formable metallized plastic. Other tin-bismuth alloys may be expected to find utility in many applications previously filled by tin/lead alloys.

## Claims

1. Use of more than 200g/l of methane sulphonic acid to inhibit hydrolytic precipitation of bismuth, in an electroplating process which electroplates tin-bismuth alloy of at least 10wt% bismuth from an aqueous electroplating bath containing soluble tin and bismuth species.

2. Use according to claim 1, in which the electroplating process electroplates tin-bismuth alloy of substantially eutectic composition.

## Patentansprüche

1. Verwendung von mehr als 200 g/l Methansulfonsäure zur Inhibierung hydrolytischer Präzipitation von Wismuth in einem Elektorplattierungsverfahren, worin eine Zinn-Wismuth-Legierung von mindestens 10 Gew.-% Wismuth aus einem wässrigen, lösliche Zinn- und Wismuthverbindungen enthaltenden Elektroplattierungsbad elektroplattiert wird.

2. Verwendung nach Anspruch 1, wobei in dem Elektroplattierungsverfahren eine Zinn-Wismuth-Legierung einer im wesentlichen eutektischen Zusammensetzung elektroplattiert wird.

## Revendications

1. Utilisation d'une quantité supérieure à 200 g/l d'acide méthanesulfonique pour inhiber la précipitation hydrolytique du bismuth, dans un procédé d'électrodéposition qui provoque l'électrodéposition d'un alliage étain-bismuth comprenant au moins 10 % en poids de bismuth dans un bain aqueux d'électrodéposition contenant des composés solubles d'étain et de bismuth.

2. Utilisation suivant la revendication 1, dans laquelle le procédé d'électrodéposition provoque l'électrodéposition d'un alliage étain-bismuth ayant une composition pratiquement eutectique.
